(19) Europäisches Patentamt
European Patent Office
Office européen des brevets

(11) **EP 4 216 294 A1**

(12) **EUROPEAN PATENT APPLICATION**

(43) Date of publication:
**26.07.2023 Bulletin 2023/30**

(21) Application number: **22153169.2**

(22) Date of filing: **25.01.2022**

(51) International Patent Classification (IPC):
***H01L 41/193*** (2006.01)　　***H01L 41/333*** (2013.01)

(52) Cooperative Patent Classification (CPC):
**H10N 30/084; H10N 30/857**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Nederlandse Organisatie voor toegepast-natuurwetenschappelijk Onderzoek TNO**
**2595 DA 's-Gravenhage (NL)**

(72) Inventors:
• **PETERS, Laurens Christiaan Johannes Maria**
  **2595 DA 's-Gravenhage (NL)**
• **GELINCK, Gerwin Hermanus**
  **2595 DA 's-Gravenhage (NL)**
• **VAN NEER, Paul Louis Maria Joseph**
  **2595 DA 's-Gravenhage (NL)**

(74) Representative: **V.O.**
  **P.O. Box 87930**
  **2508 DH Den Haag (NL)**

(54) **METHOD OF MOLDING A PIEZOELECTRIC PILLAR DEVICE**

(57)　　A piezoelectric device (100) is manufactured using a substrate (20) with a piezoelectric moldable layer (10). A stamp (30) comprises a repeating pattern of unit cells (30u) formed by a grid of interconnected sidewalls (32) separating respective apertures (31). A molding process comprises pushing (F) the stamp (30) into the moldable layer (10). This causes the piezoelectric material (M) to be pushed into the respective apertures (31) and form an array of pillars (11). In the stamp, the fraction of open area (A31), formed by a respective aperture (31), is more than the fraction of solid area (A32), formed by the surrounding sidewalls (32). In the resulting pillar structure the fraction of active area (A11), formed by the pillars (11) is more than the fraction of inactive area (A12) between the pillars (11). The stamp (30) can be adapted to improve structural integrity while using relatively thin sidewalls (32).

FIG 1A

EP 4 216 294 A1

**Description**

TECHNICAL FIELD AND BACKGROUND

The present disclosure relates to piezoelectric devices, such as acoustic transducers, comprising three dimensional pillar structures of piezoelectric material, and methods of manufacturing such devices, in particular using a molding process, e.g. stamping.

As one application, pillar structures can be advantageous in lowering acoustical and/or mechanical cross coupling between elements in an acoustic device. In one publication, Chen et al. [DOI: 10.1039/C5NR01746G] describes High Performance P(VDF-TrFE) Nanogenerator with Self-Connected and Vertically Integrated Fibers by Patterned EHD Pulling. In another publication, Chen et al. [DOI: 10.1002/smll.201604245] describes High-Performance Piezoelectric Nanogenerators with Imprinted P(VDF-TrFE)/BaTiO3 Nanocomposite Micropillars for Self-Powered Flexible Sensors. In another publication, Xu et al. [DOI: 10.1117/12.817028] describes Design and Microfabrication of a PVDF Acoustic Sensor.

As further background, WO 2021/167446 A1 discloses a piezoelectric device and method of manufacturing. The contents of this prior art are enclosed herein in their entirety, including the various manufacturing steps to produce a piezoelectric device. The prior art discloses that the manufacturing may comprise forming an array of pillars by molding. In particular, the formation may comprise pushing a molding structure (stamp) with a surface topology, e.g. mold openings or holes, into a moldable layer on a substrate. Accordingly, the piezoelectric material of the moldable layer can be pushed into respective mold openings to form respective pillars. For example, the piezoelectric material in the moldable layer is softened, e.g. by heating, prior to and/or during the molding. This may facilitate deforming the material in the shape of pillars. The material of the pillars may solidified, e.g. by active or passive cooling, before removing the mold.

There remains a need for further improvement in the manufacturing of high performance piezoelectric devices with pillars, in particular using a molding process and stamp.

SUMMARY

Aspects of the present disclosure relate to piezoelectric devices and methods of manufacturing such devices. A substrate is provided with a moldable layer comprising a piezoelectric material. A stamp, e.g. molding structure, comprises a repeating pattern of unit cells formed by a grid of interconnected sidewalls separating respective apertures there between. In each respective unit cell, the sidewalls enclose a respective aperture of the respective unit cell. In a stamping process, e.g. a molding and/or embossing step, the stamp is pushed mechanically into the moldable layer (or vice versa). This may cause the moldable layer to be at least partially cut by the grid of interconnected sidewalls and/or cause the piezoelectric material to be pushed into the respective apertures. In this way a two-dimensional array of three-dimensional pillars can be formed comprising the piezoelectric material. For example, each pillar is formed with a shape complementary to the shape of the respective aperture in the stamp. The resulting device may also include a residual layer of the piezoelectric (previously moldable) material which is integrally connected with the pillar structure.

It will be understood that in each respective unit cell of the stamp, a fraction of open area is formed by the respective aperture, and a (complementary) fraction of solid area is occupied by the surrounding sidewalls. The inventors find that, by making the fraction of open area in the stamp (much) higher than the fraction of solid area occupied by the walls, the area of active regions occupied by the piezoelectric pillars formed in the molding process will be correspondingly higher than the area of the gaps between the pillars without the piezoelectric material. By having a relatively high fraction of the piezoelectric array occupied by the active piezoelectric material, operation of the resulting piezoelectric device may be improved, e.g. compared to a sparse array of pillars. For example, because the area in between the resulting pillar elements essentially does not contribute to the piezoelectric response and is 'functionally dead area', this area is preferably minimized. In principle, this can be achieved by using embossing structures on the stamp that are relatively thin, e.g. using relatively thin walls between the apertures. However, while small embossed trenches between the piezoelectric pillars can result in a dense packing of the elements, this can be technologically challenging to realize. For example, the inventors find that a molding structure, such as a PDMS stamp, with small line width of the walls (high-aspect-ratio) and large lateral length of the line/wall (distance between crossings) can be mechanically unstable and may suffer from structural collapse or buckle during molding / embossing of the moldable layer.

One solution to alleviate the issue of buckling may include using a relatively hard stamp or molding structure. However, the inventors find that such hard stamps may suffer from poor contact over a large area and/or poor release of the molded material from the stamp. Another or further solution may include imprinting softer materials. For example, moldable piezoelectric materials such as P(VDF-TrFE) may softens with rising temperature, but this can be done only up to certain critical temperature. So the inventors propose specific structural adaptations of the molding structure which maximizes the active area of the resulting pillar elements while maintaining the integrity of the stamp during the molding process. Guiding principles in the adaptation include avoiding long and thin walls on the stamp while keeping the overall area maximized, e.g. creating densely packed structures.

Advantageously, the stamp or mold as described herein can be manufactured using a freeform process, e.g. including lithography, that allows various new shapes which are not feasible using traditional sawing of a piezoelectric layer. For example, the inventors find that, by using patterns which include zigzagging and/or curved wall segments instead of long straight walls, the buckling of wall segments can be alleviated. The inventors also find that wall segments between intersection of different unit cells can be shortened using a staggered arrangement. The inventors also find that wall segments can be fortified using intermediate wall structures or thickening. As shown by calculations and simulations, described herein, the inventors find that, using a hexagonal pattern instead of a square or triangular pattern, overall improvement of the active area can be achieved including optimal utilization of this area by electric signals.

BRIEF DESCRIPTION OF DRAWINGS

These and other features, aspects, and advantages of the methods and devices of the present disclosure will become better understood from the following description, appended claims, and accompanying drawing wherein:

FIGs 1A and 1B illustrate a method of manufacturing a piezoelectric device and a resulting device;
FIG 2A illustrates a pattern of unit cells formed as part of a stamp;
FIG 2B illustrates further details of unit cell;
FIG 3A illustrates a pattern of unit cells including zigzagged wall segments;
FIG 3B illustrates a pattern of unit cells including curved wall segments;
FIG 4A illustrates a pattern of unit cells including intermediate wall structures;
FIG 4B illustrates a pattern of staggered unit cells;
FIG 4C illustrates a combination of staggered unit cells and intermediate wall structures;
FIGs 5A-5C illustrate a comparison of active area for unit cells with different patterns;
FIG 6 illustrate a graph of the fraction of active area as function of the relative gap size for different patterns;
FIGs 7A and 7B illustrate a simulation of electric field strength in piezoelectric pillars having a square and hexagonal shape, respectively.

DESCRIPTION OF EMBODIMENTS

Terminology used for describing particular embodiments is not intended to be limiting of the invention. As used herein, the singular forms "a", "an" and "the" are intended to include the plural forms as well, unless the context clearly indicates otherwise. The term "and/or" includes any and all combinations of one or more of the associated listed items. It will be understood that the terms "comprises" and/or "comprising" specify the presence of stated features but do not preclude the presence or addition of one or more other features. It will be further understood that when a particular step of a method is referred to as subsequent to another step, it can directly follow said other step or one or more intermediate steps may be carried out before carrying out the particular step, unless specified otherwise. Likewise it will be understood that when a connection between structures or components is described, this connection may be established directly or through intermediate structures or components unless specified otherwise.

The invention is described more fully hereinafter with reference to the accompanying drawings, in which embodiments of the invention are shown. In the drawings, the absolute and relative sizes of systems, components, layers, and regions may be exaggerated for clarity. Embodiments may be described with reference to schematic and/or cross-section illustrations of possibly idealized embodiments and intermediate structures of the invention. In the description and drawings, like numbers refer to like elements throughout. Relative terms as well as derivatives thereof should be construed to refer to the orientation as then described or as shown in the drawing under discussion. These relative terms are for convenience of description and do not require that the system be constructed or operated in a particular orientation unless stated otherwise.

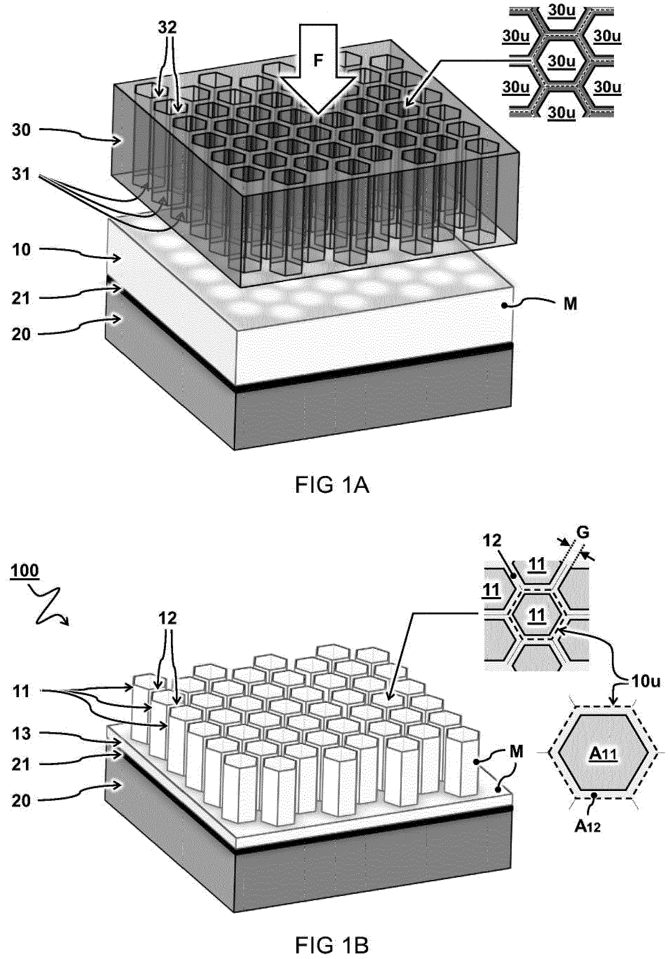

FIGs 1A and 1B illustrate a method of manufacturing a piezoelectric device 100.

In some embodiments, e.g. as shown in FIG 1A, a substrate 20 is provided with a moldable layer 10. Preferably, the moldable layer 10 and/or the resulting pillars 11 comprise or essentially consist of a piezoelectric material "M". It will be understood that the term moldable layer 10 is used to reference the precursor layer, as shown in FIG 1A, before it takes its final shape forming a structure of pillars 11, as shown in FIG 1B. It does not necessarily indicate a change in material functionality (as in chemical precursor). For example, the piezoelectric material may have piezoelectric functionality before and after the molding, but in a different shape. In a preferred embodiment, the piezoelectric material "M" comprises or essentially consists of piezoelectric polymers. Most preferably, the piezoelectric material comprises or essentially consists of a polymeric or a composite polymeric/ceramic material. Examples of polymeric piezoelectric materials may include PVDF and its co-polymers, polyamides, liquid crystal polymers, polyimide and polyvinylidenechloride PVDC.

In some embodiments, a stamp 30 is provided with a repeating pattern of unit cells 30u. Preferably, the unit cells 30u are identical or essentially similar. In one embodiment, the pattern of units unit cell 30u is formed by a grid of interconnected sidewalls 32. Preferably, the sidewalls 32 form a contiguous wall structure. In another or further embodiment, the sidewalls 32 are configured to separate respective apertures 31 there between. Preferably, in each respective unit cell 30u, the sidewalls 32 enclose a respective aperture 31 of the respective unit cell 30u.

Some embodiments comprise performing a molding process, e.g. stamping and/or embossing the moldable layer 10. In one embodiment, the molding process comprises pushing the stamp 30 (indicated by arrow "F") into the moldable layer 10. Of course the moldable layer 10 is then also pushed into the stamp. Preferably, the pushing causes the moldable layer 10 to be at least partially cut by the grid of interconnected sidewalls 32 and/or the pushing causes the piezoelectric material "M" to be pushed into the respective apertures 31. In this way an array of pillars 11 comprising the piezoelectric material "M" can be formed. For example, (the shape of) each pillar 11 is formed according to (the shape of) a respective aperture 31. In some embodiments, the piezoelectric material "M" in the moldable layer 10 is softened, e.g. by heating, prior to and/or during the molding. This may facilitate deforming the material in the shape of pillars. The material of the pillars may solidified, e.g. by active or passive cooling, before removing the mold. Alternatively, or additionally, the pillars can be made by molding soft (e.g. sol-gel) layers that are cured afterwards, e.g. by UV radiation.

In some embodiments, the substrate 20 forms a support structure under the array of pillars 11. Typically, the substrate 20 is of a different material than the pillars, e.g. not a piezoelectric material. For example, the substrate 20 comprises a plastic, glass, or silicon substrate. Alternatively, the substrate 20 may itself comprise piezoelectric material "M" essentially being formed only by the moldable layer 10. By using a flexible substrate as the substrate 20, it may be easier to separate the mold structure 30 from the pillars 11 after formation. Alternatively, or in addition, also the mold structure 30 can be flexible.

In a preferred embodiment, e.g. as shown, the lengths of the pillars 11 have a direction perpendicular to a plane of the substrate 20, with the respective ends facing away from the substrate 20. Alternatively, or additionally, it can be envisaged that some, or all pillars are directed at an angle with respective to a surface normal of the substrate 20.

Aspects of the present disclosure can also be embodied as a piezoelectric device 100 manufactured according to the methods described herein. In some embodiments, e.g. as shown in FIG 1B, the piezoelectric device 100 comprises a substrate 20 with a pillar structure formed of a molded piezoelectric material "M". In one embodiment, the pillar structure comprises a repeating pattern of (identical or essentially similar) unit cells 10u formed by a grid of interconnected spacing 12 separating the piezoelectric material "M" of respective pillars 11 there between. Preferably, the spacing 12 is formed by open (contiguous) gap. Alternatively, or additionally a non-piezo-electric filler material can be provided between the pillars. Typically, in each respective unit cell 10u, the spacing 12 encloses a respective pillar 31 of the respective unit cell 10u. In one embodiment, e.g. as shown, the pillar structure is integrally formed on a residual layer 13 of the piezoelectric material "M" left over after molding of the pillar structure.

In some embodiments, the resulting array of pillars comprises at least ten pillars, preferably at least twenty pillars, more preferably at least fifty pillars, most preferably at least hundred pillars, e.g. up to thousand pillars, or more. Preferably, the array of pillars is a two-dimensional array, e.g. having at least three, five, ten or more pillars arranged in each row and/or at least three, five, ten or more pillars arranged in another direction transverse to the row, e.g. column. It will be noted that, e.g. in a hexagonal grid and/or staggered grid, the rows and columns may be at other angles than a perpendicular ninety degree (plane) angle. For example, the rows and columns may be at sixty degrees or forty-five degrees.

It will also be understood that the pattern of the stamp 30 is typically the same but complementary to the pattern the pillar structure. So any embodiments described herein with regards the layout and dimensions of the stamp 30, e.g. wall thickness, wall length, relative arrangement of walls, pitch, period, et cetera, can be mutatis mutandis applicable in, and embodied by, the resulting pillar structure, e.g. the gap width, gap length, relative arrangement of gaps, pitch, period, et cetera. For example, the pillars and apertures typically have relatively small cross-section dimension, e.g. with a minimum diameter in a range between 10 - 500 micrometer, preferably between 20 - 300 micrometer, most preferably between 40 - 200 micrometer. Preferably, as described herein, the (minimum) gap size "G" of the spacing 12 between the pillars 11, corresponding to the (minimum) thickness of sidewalls 32 between the apertures 31, is smaller than the said minimum diameter, e.g. less than twenty micrometers, less than ten micrometers, less than five micrometers, down to one micrometer, or less. A length of the pillars 11 (transverse to the substrate) is preferably the same or more than their (minimum) cross-section diameter, e.g. in a range between 10 - 500 micrometer, preferably between 20 - 300 micrometer, most preferably between 40 - 200 micrometer. For example, the pillar height is more than the pillar width by at least twenty percent, at least fifty percent, up to a factor two, or more. The depth of the apertures 31 in the stamp is preferably be the same as the height of the pillars 11, but can also be higher (e.g. with an open end as shown in FIG 1A).

Piezoelectric devices such as described herein can be used to transmit and/or receive acoustic signals, e.g. ultrasound. For example, a voltage can be applied to generate an electric field through the piezoelectric material "M" of the pillars 11 to actuate a vibration in the pillars. Alternatively, or in addition, a voltage can be measured depending on a vibration in the pillars 11, e.g.

caused by an external source. In some embodiments (not shown), a respective one or more of the pillars 11 are connected via respective electrodes to an electrical device configured to transceive electrical signals there between. For example, the electrical device comprises a signal generator and/or sensor device. Also other or further components can be connected such as a controller to determine which one or more of the pillars 11 is addressed.

In some embodiments, the piezoelectric device 100 comprises an electrode 21 configured to apply and/or receive an electrical signal from the pillars. In one embodiment, the piezoelectric device 100 comprises one or more bottom electrodes at a bottom end of the pillars 11. In another or further embodiment (not shown here), the piezoelectric device 100 comprises one or more top electrodes at a top end of the pillars 11. For example, one or both of the bottom and/or top electrodes can be configured to individually and/or collectively address respective pillars. In some embodiments, e.g. as shown, the bottom electrode 21 is disposed between the residual layer 13 and the substrate 20, e.g. acting as a support substrate. For example, the bottom electrode 21 comprises an electrically conducting layer and/or circuitry to electrically interact with respective pillars. In other or further embodiments (not shown), the piezoelectric device 100 comprises a controller to send and/or receive electrical signals to/from the piezoelectric pillar structure.

In some embodiments, electrical connections and/or components are incorporated in or on the substrate 20. For example, these can be formed lithographically, e.g. on a silicon or other material substrate. In some embodiments, one or more further layers are formed between the moldable layer 10 and the substrate 20. For example, the additional layers may have an electrical or other function. Preferably, at least a first electrode 21 is formed between the pillars 11 and the substrate 20 for applying an electric potential (voltage) to the piezoelectric material "M". For example, the first electrode 21 comprises a conductive layer, e.g. metal, which may be patterned or not. In some embodiments, the first electrode 21 is a common electrode to apply the same voltage to all of the pillars. For example, the first electrode 21 is a continuous metal layer that runs under all the pillars. In other or further embodiments, the first electrode 21 is subdivided to individually address (apply a respective voltage to) one pillar, or multiple pillars, e.g. a subset of all pillars. For example, one electrode may cover a collection or cluster of adjacent pillars.

In other or further embodiments, the other ends of the pillars (facing away from the substrate), are provided with a second electrode (not shown). For example, the piezoelectric pillars can be configured as thickness mode transducers. In one embodiment, one or more second electrode are applied directly onto the pillars. Optionally, an extra piezoelectric layer can be applied to, e.g. bonded, on top of the pillars as explained in the prior publication WO 2021/167446 A1. For example, the extra piezoelectric layer can help to structurally fortify the pillar array and/or act as a platform for depositing further circuitry such as one or more second electrodes.

As illustrated on the right side of FIG 1B, in each respective unit cell 10u of the pillar structure, a fraction of active area "$A_{11}$" is occupied by the piezoelectric material "M" of the respective pillar 11, and a (complementary) fraction of inactive area "$A_{12}$" is formed by the spacing 12 between the pillars. As described herein, the fraction of active area "$A_{11}$" is preferably more than the fraction of inactive ('dead') area "$A_{12}$", e.g. by at least a factor two, preferably at least a factor three, more preferably at least a factor five, e.g. up to a factor ten, or more. The higher the fraction of active area, the more effective the performance per unit area of the piezoelectric device 100.

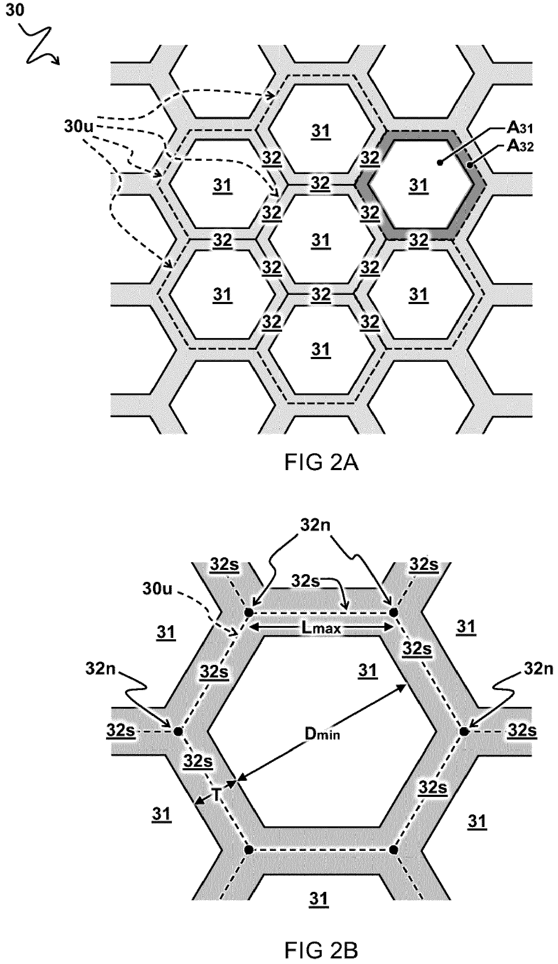

FIG 2A illustrates a pattern of unit cells 30u formed as part of a stamp 30. Typically, in each respective unit cell 30u of the stamp 30, a fraction of open area "$A_{31}$" is formed by the respective aperture 31, and a (complementary) fraction of solid area "$A_{32}$" is occupied by the surrounding sidewalls 32. In a preferred embodiment, the fraction of open area "$A_{31}$" is more than the fraction of solid area "$A_{32}$". Accordingly, as described above, the active area "$A_{11}$" of active regions occupied by the piezoelectric pillars 11 (formed in the molding process) will be higher than the inactive area "$A_{12}$" of the gaps 12 between the pillars without the piezoelectric material. In one embodiment, the fraction of open area "$A_{31}$" is more than the fraction of solid area "$A_{32}$" by at least a factor two, preferably at least a factor three, most preferably at least a factor five, e.g. up to a factor ten, or more. Typically, the

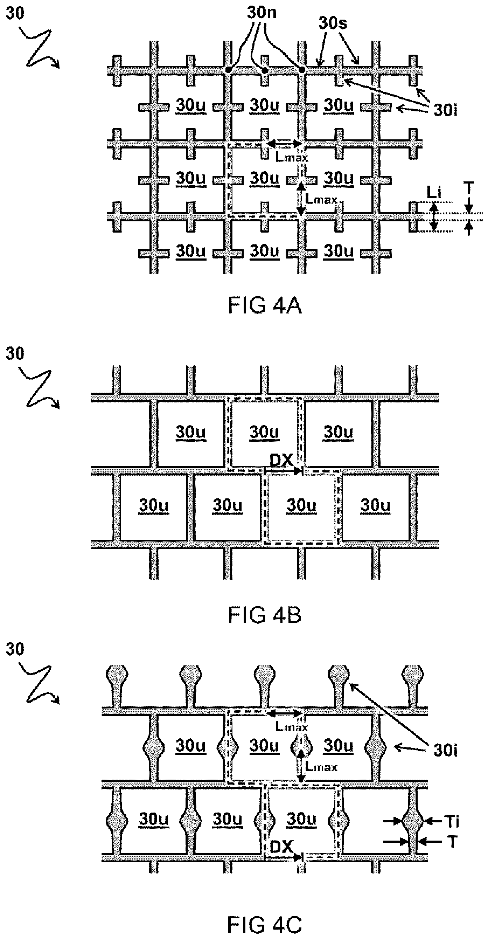

FIG 2B illustrates further details of a unit cell 30u. In some embodiments, the sidewalls 32 comprise surrounding wall segments 32s which are shared with adjacent unit cells surrounding the respective unit cell 30u. In other or further embodiments, the grid of interconnected sidewalls 32 (e.g. in plan view) is defined by a set of nodes 32n at respective intersections of the grid. For example, a node 32n is defined at each intersection of the grid where at least three wall segments 32s of the sidewalls 32 (having at least two different directions) intersect each other. For example, the three wall segments 32s may correspond to different unit cells and/or the same unit cell (in case of an intermediate wall structure as shown, e.g., in FIG 4A).

In one preferred embodiment, the surrounding wall segments 32s (at least those shared between adjacent unit cells 30u) have a minimum wall thickness "T" that is smaller than a minimum (inner) cross-section diameter "$D_{min}$" of the respective aperture 31, e.g. by at least a factor two, three, five, up to a factor ten, or more. For example, the minimum cross-section diameter can be measured through a center of the aperture, e.g. the center of rotational symmetry (order≥2). As will be appreciated, the minimum wall thickness "T" compared to the minimum cross-section diameter "$D_{min}$" of the aperture will determine the minimum cross-section diameter of the resulting pillar 11 compared to the spacing, e.g. gap, between the pillars. The smaller the gap relative to the cross-section, the larger the active area can be.

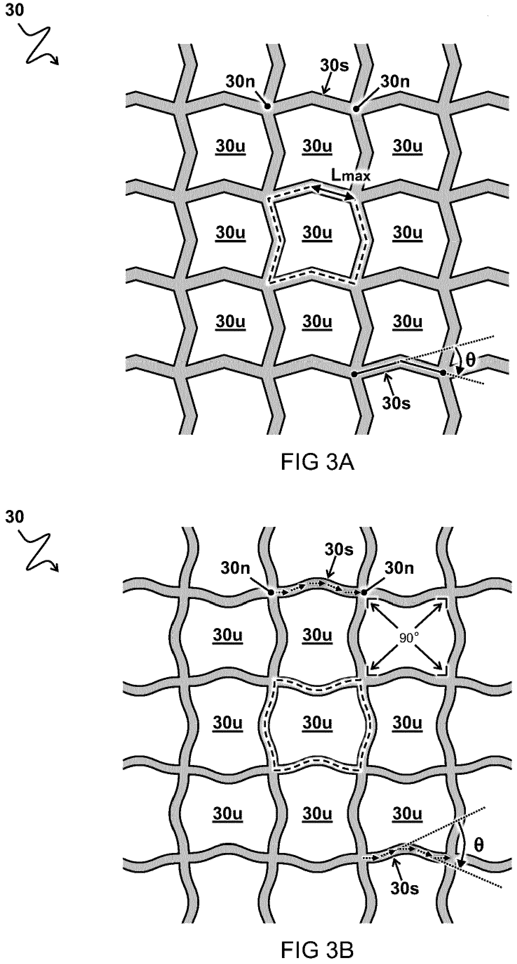

In another or further preferred embodiment, a maximum wall length "$L_{max}$" of any straight wall segment 32s in the grid of interconnected sidewalls 32 is smaller than the minimum cross-section diameter "$D_{min}$" of any aperture 31 formed along said straight wall segment 32s. For example, the wall length may be measured in a plan view of the repeating pattern of unit cells 30u (e.g. in a plane parallel to the stamp 30 and/or moldable layer 10). The inventors find that by avoiding long straight wall segments, e.g. relative to the minimum cross-section diameter of the adjacent aperture, the structural integrity of the walls during the molding process may be improved. For example, in a conventional pattern formed by a square grid of sidewalls, the wall segments may be formed along relatively long straight lines between the rows and columns of the square shaped apertures there between. Conversely, the preferred structures as described herein can be formed by relatively short line segments that are e.g. zig-zagged and/or curved to help alleviate buckling of the wall segments during molding, especially when the wall thickness is made relatively small to reduce spacing between the resulting pillars and/or improve the active area. For example, the maximum straight wall length "$L_{max}$" can be smaller than the minimum cross-section diameter "$D_{min}$" by at least twenty percent (factor 0.8) such as in the hexagonal pattern of FIGs 1 and 2. The maximum straight wall length can also be smaller, e.g. using a zigzag pattern as shown in FIG 3A. Alternatively, or additionally, straight wall segments can be avoided, e.g. using curved wall segments as shown in FIG 3B. In some embodiments, the respective unit cell 30u has a maximum diameter (not indicated) defined as a distance between a pair of further apart nodes surrounding the respective unit cell 30u. In one embodiment, the longest straight wall segment anywhere in the repeating pattern of unit cells 30u is smaller than the maximum diameter and/or smaller than the minimum diameter.

In another or further preferred embodiment, a wall length "$L_{max}$" of any (straight or curved) wall segment 32s, between a respective pair of closest nodes 32n, is smaller than the minimum cross-section diameter "$D_{min}$" of any aperture 31 formed along said wall segment 32s, e.g. by at least twenty percent. For example, the straight or curved wall segment 32s can be anywhere in the grid of interconnected sidewalls 32. As will be appreciated, the wall segments can be structurally fortified at the nodes by the additional wall segments having different directions. By keeping the wall length between nodes relatively short, e.g. shorter than the minimum cross-section diameter of the aperture, the overall structural integrity of the sidewalls can be improved and buckling during the molding process can be alleviated. For example, in a conventional pattern formed by a square grid of sidewalls, the wall segments between nodes have essentially the same length as the square shaped apertures. Conversely, the preferred structures as described herein can have line segments between respective nodes that are shorter than the diameter of the aperture. For example, the wall length between the closest nodes can be smaller than the minimum cross-section diameter "$D_{min}$" by at least twenty percent (factor 0.8) such as in the hexagonal pattern of FIG 2. The wall length between the closest nodes can also be smaller, e.g. by alternatively or additionally applying intermediate wall structures 32i such as shown in FIG 4A. Alternatively, or additionally, the wall length between the closest nodes can be shortened by using a staggered pattern such as shown in FIG 4B. Also combinations of intermediate wall structures and staggered patterns can be used, such as shown in FIG 4C.

FIG 3A illustrates a pattern of unit cells 30u including zigzagged wall segments 30s. FIG 3B illustrates a pattern of unit cells 30u including curved wall segments 30s. In some embodiments, at least some (preferably all) wall segments 32s between a pair of closest nodes 30n (at intersections where three or more wall segments meet) surrounding a respective aperture 31, have a kink and/or curvature changing a direction θ of the wall segment 32s along a path between the closest nodes, e.g. by at least five degrees plane angle, preferably at least ten or twenty degrees, e.g. up to forty-five degrees, or more.

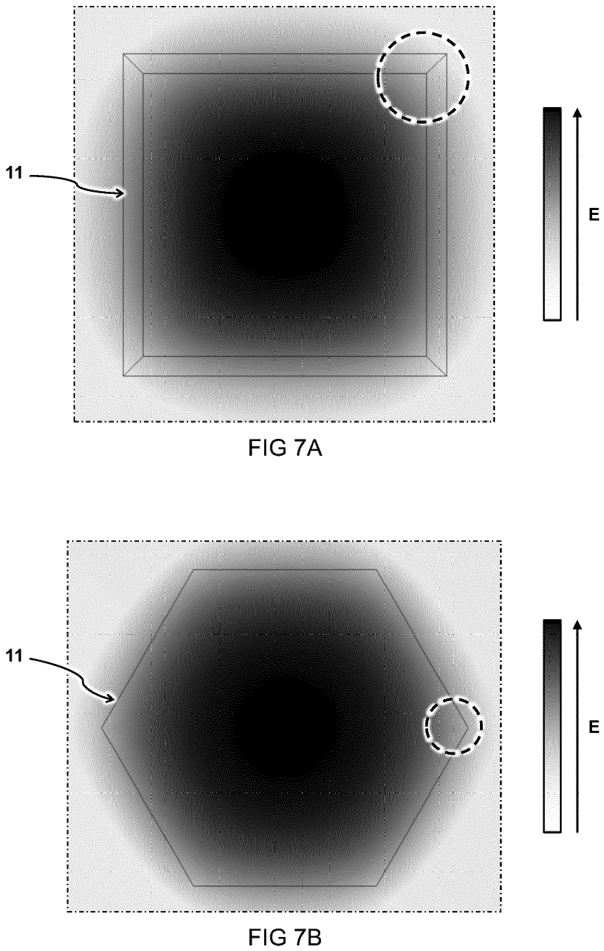

In other or further embodiments, three of four wall segments 32s of different unit cells 30u meet at respective intersections preferably having an angle of at least ninety degrees (e.g. when there are four unit cells bordering the intersection as shown by the 90° indication in FIG 3B), or at least hundred-twenty degrees (e.g. when there are three unit cells like in the hexagonal pattern). For example, in the curved pattern, it is preferred that the curvature straightens out before the node so the angle between wall segments is maximized. A similar effect can be achieved by introducing additional kinks in the pattern of FIG 3A (not shown). Avoiding sharp angles between the wall segments may improve the electric field in the corresponding pillars, as e.g. illustrated in FIGs 7A and 7B.

FIG 4A illustrates a pattern of unit cells 30u including intermediate wall structures 30i. FIG 4B illustrates a pattern of staggered unit cells 30u (e.g. laterally offset and/or running bond). FIG 4C illustrates a combination of staggered unit cells 30u and intermediate wall structures 30i. In some embodiments, at least some wall segments 32s between nodes 30n (forming intersections of the sidewalls 32 between three or more unit cells 30u) comprise an intermediate wall structure 32i formed by a transverse wall segment and/or local thickening of the wall segment 32s. For example, a length "Li" of the transverse wall (pointing into and out of the aperture) and/or a thickness "Ti" of the local thickening is higher than a minimum thickness "T" of the rest of the wall segment by at least a factor two, three, e.g. up to a factor five, or more. In other or further embodiments, the unit cells 30u are staggered. For example, a first row of unit cells is displaced with respect to an adjacent second row of unit cells. In one embodiment, the displacement "DX" is between a fraction of 0.4 - 0.6 times a dimension of the unit cells along the respective row, preferably half said dimension (i.e. such that one or more, preferably each, unit cell of the first row is in the middle between two unit cells of the second row).

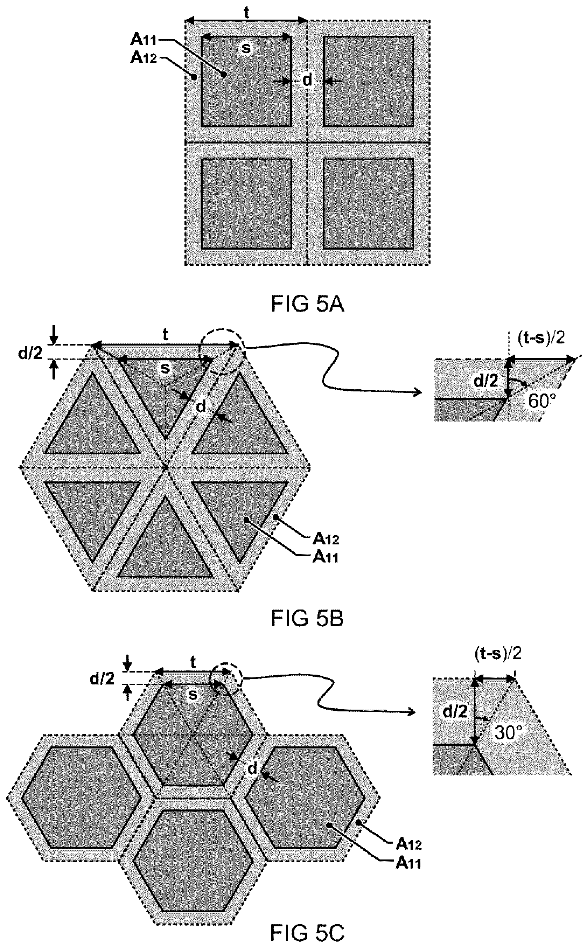

FIGs 5A-5C illustratesa comparison of active area for unit cells with different patterns. It can be shown that the fraction of active area "A" $=A_{11}/(A_{11}+A_{12})$ may be calculated as follows.

For a square pattern:

$$A = \frac{s^2}{t^2} = \frac{s^2}{s + d^2}$$

For a triangular pattern:

$$A = \frac{\frac{1}{4}\sqrt{3}s^2}{\frac{1}{4}\sqrt{3}t^2} = \frac{s^2}{\left(s + d\sqrt{3}\right)^2}$$

For a hexagonal pattern:

$$A = \frac{\frac{3}{2}\sqrt{3}s^2}{\frac{3}{2}\sqrt{3}t^2} = \frac{s^2}{\left(s + d/\sqrt{3}\right)^2}$$

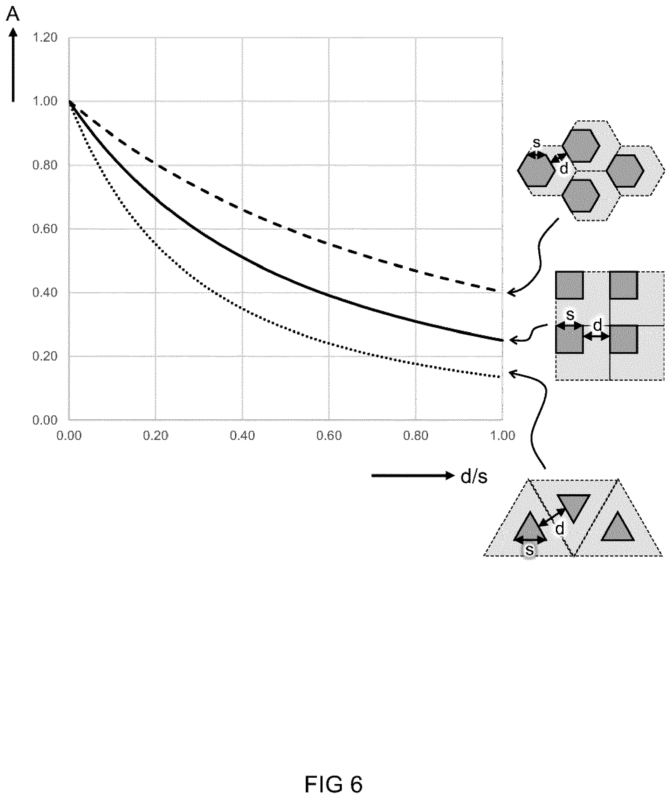

FIG 6 illustrate a graph of the fraction of active area A as function of the relative gap size *d/s* for different patterns. It may be noted that using a hexagonal pattern can provide a relatively large fraction of active area for a respective relative gap size d/s compared to a square pattern while a triangular pattern provides a relatively low fraction of active area.

FIGs 7A and 7B illustrate a simulation of electric field strength E in piezoelectric pillars having a square and hexagonal shape, respectively. It may be noted that the relatively obtuse internal angle of 120° in a hexagonal pattern can allow better penetration of the electric field E in the corners compared to the smaller angle of 90° in a square pattern. Accordingly, in some embodiments, the overall utilization of the active area can be further improved by maximizing the internal angles such as in using hexagonal or other patterns.

In interpreting the appended claims, it should be understood that the word "comprising" does not exclude the presence of other elements or acts than those listed in a given claim; the word "a" or "an" preceding an element does not exclude the presence of a plurality of such elements; any reference signs in the claims do not limit their scope; several "means" may be represented by the same or different item(s) or implemented structure or function; any of the disclosed devices or portions thereof may be combined together or separated into further portions unless specifically stated otherwise. Where one claim refers to another claim, this may indicate synergetic advantage achieved by the combination of their respective features. But the mere fact that certain measures are recited in mutually different claims does not indicate that a combination of these measures cannot also be used to advantage. The present embodiments may thus include all working combinations of the claims wherein each claim can in principle refer to any preceding claim unless clearly excluded by context.

**Claims**

1. A method of manufacturing a piezoelectric device (100), the method comprising

   providing a substrate (20) with a moldable layer (10) comprising a piezoelectric material (M);
   providing a stamp (30) comprising a repeating pattern of unit cells (30u) formed by a grid of interconnected sidewalls (32) separating respective apertures (31) there between, wherein in each respective unit cell (30u) the sidewalls (32) enclose a respective aperture (31) of the respective unit cell (30u);
   performing a molding process comprising pushing (F) the stamp (30) into the moldable layer (10), or vice versa, to cause the moldable layer (10) to be at least partially cut by the grid of interconnected sidewalls (32) and the piezoelectric material (M) to be pushed into the respective apertures (31) to form an array of pillars (11), comprising the piezoelectric material (M), wherein each pillar (11) is formed according to the respective aperture (31);
   wherein, in each respective unit cell (30u) of the stamp (30), a fraction of open area ($A_{31}$) is formed by the respective aperture (31), and a complementary fraction of solid area ($A_{32}$) is occupied by the surrounding sidewalls (32), wherein the fraction of open area ($A_{31}$) per unit cell (30u) of the stamp is more than the fraction of solid area ($A_{32}$).

2. The method according to the preceding claim, wherein the sidewalls (32) comprise surrounding wall segments (32s) which are shared with adjacent unit cells surrounding the respective unit cell (30u), wherein the surrounding wall segments (32s), shared between adjacent unit cells (30u), have a minimum wall thickness (T) that is smaller than a minimum cross-section diameter ($D_{min}$) of the respective aperture (31) by at least a factor two.

3. The method according to the preceding claim, wherein, in a plan view of the repeating pattern of unit cells (30u), a maximum wall length ($L_{max}$) of any straight wall segment (32s), forming part of the grid of interconnected sidewalls (32), is smaller than the minimum cross-section diameter ($D_{min}$) of any aperture (31) formed along said straight wall segment (32s).

4. The method according to any of the preceding claims, wherein the grid of interconnected sidewalls (32) is defined by a set of nodes (32n) at respective intersections of the grid where at least three wall segments (32s) of the sidewalls (32) intersect each other, wherein a wall length of any wall segment (32s) between a respective pair of closest nodes (32n) is smaller than the minimum cross-section diameter ($D_{min}$) of any aperture (31) formed along said wall segment (32s) by at least twenty percent.

5. The method according to any of the preceding claims, wherein at least some wall segments (32s) between a pair of closest nodes (30n), at intersections where three or more wall segments meet surrounding a respective aperture (31), have a kink and/or curvature changing a direction ($\theta$) of the wall segment (32s) along a path between the closest nodes by at least ten degrees.

6. The method according to the preceding claim, wherein three of four wall segments (32s) of different unit cells (30u) meet at respective intersections having an angle of at least ninety degrees.

7. The method according to any of the preceding claims, wherein at least some wall segments (32s) between nodes (30n) forming nearest intersections of the sidewalls (32) between three or more unit cells (30u) comprise an intermediate wall structure (32i) formed by a transverse wall segment, with a length (Li) oriented transverse to a length of the respective wall segment

8. The method according to any of the preceding claims, wherein at least some wall segments (32s) between nodes (30n) forming nearest intersections of the sidewalls (32) between three or more unit cells (30u) comprise an intermediate wall structure (32i) formed by a local thickening of the wall segment (32s), wherein a thickness (Ti) of the local thickening is higher than a minimum thickness (T) of the rest of the wall segment by at least a factor two.

9. The method according to any of the preceding claims, wherein the pattern of unit cells (30u) comprises staggered rows of unit cells (30u), wherein a first row of unit cells is displaced with respect to an adjacent second row of unit cells, wherein unit cells of the first row are displaced with an offset (Dx) midway between two unit cells of the second row.

10. The method according to any of the preceding claims, wherein the pattern of unit cells (30u) comprises a hexagonal pattern.

11. The method according to any of the preceding claims, wherein the stamp (30) is manufactured using a lithographic process.

12. A piezoelectric device (100) manufactured according to the method of any of the preceding claims, the piezoelectric device (100) comprising

a substrate (20) with a pillar structure formed of a molded piezoelectric material (M);
wherein the pillar structure comprises a repeating pattern of unit cells (10u) formed by a grid of interconnected spacing (12) separating the piezoelectric material (M) of respective pillars (11) there between, wherein in each respective unit cell (10u) the spacing (12) encloses a respective pillar (31) of the respective unit cell (10u),
wherein the pillar structure is integrally formed on a residual layer (13) of the piezoelectric material (M) left over after molding of the pillar structure,
wherein, in each respective unit cell (10u) of the pillar structure, a fraction of active area ($A_{11}$) is occupied by the piezoelectric material (M) of the respective pillar (11), and a complementary fraction of inactive area ($A_{12}$) is formed by the spacing (12) between the pillars, wherein the fraction of active area ($A_{11}$) per unit cell (10u) of the pillar structure is more than the fraction of inactive area ($A_{12}$).

13. The device according to claim 12, wherein a minimum spacing (12) between adjacent pillars (11) in the pillar structure is less than a minimum diameter of said pillars (11) by at least a factor two.

14. The device according to claim 12 or 13, wherein pillar structure comprises a two dimensional array of pillars with at least five pillars arranged along each direction of the array, wherein each pillar has a hexagonal cross-section shape with a minimum diameter less than two hundred micrometer and a spacing between the pillars less than twenty micrometer.

15. The device according to any of claims 12 - 14, wherein the piezoelectric device (100) comprises at least one electrode (21) and a controller configured to send and/or receive electrical signals to/from the piezoelectric pillar structure.

FIG 1A

FIG 1B

FIG 2A

FIG 2B

30

30n    30s    30n

30u    30u    30u

Lmax

30u    30u    30u

30u    30u    30u

θ

30s

FIG 3A

30

30s
30n         30n

30u    30u    90°

30u    30u    30u

30u    30u    30u
θ

30s

FIG 3B

FIG 4A

FIG 4B

FIG 4C

FIG 5A

FIG 5B

FIG 5C

FIG 6

FIG 7A

FIG 7B

Europäisches Patentamt

European Patent Office

Office européen des brevets

## EUROPEAN SEARCH REPORT

Application Number

EP 22 15 3169

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D | WO 2021/167446 A1 (TNO [NL]) 26 August 2021 (2021-08-26) * claim 15; figure 1 * ----- | 1,6,7, 11,15 | INV. H01L41/193 H01L41/333 |
| A | WO 2006/083245 A1 (GE INSPECTION TECHNOLOGIES LP [US]; YETTER KELLY E [US] ET AL.) 10 August 2006 (2006-08-10) ----- | 1-15 | |
| A | AU 2020 103 892 A4 (UNIV BEIJING INF SCI & TECH [CN]) 11 February 2021 (2021-02-11) ----- | 1-15 | |
| A | US 2021/190687 A1 (GE NING [US] ET AL) 24 June 2021 (2021-06-24) ----- | 1-15 | |

TECHNICAL FIELDS
SEARCHED     (IPC)

H01L

The present search report has been drawn up for all claims

| Place of search | Date of completion of the search | Examiner |
|---|---|---|
| Munich | 17 August 2022 | Koskinen, Timo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 22 15 3169

This annex lists the patent family members relating to the patent documents cited in the above-mentioned European search report.
The members are as contained in the European Patent Office EDP file on
The European Patent Office is in no way liable for these particulars which are merely given for the purpose of information.

17-08-2022

| Patent document cited in search report | | Publication date | Patent family member(s) | | Publication date |
|---|---|---|---|---|---|
| WO 2021167446 | A1 | 26-08-2021 | EP | 3869575 A1 | 25-08-2021 |
| | | | TW | 202203478 A | 16-01-2022 |
| | | | WO | 2021167446 A1 | 26-08-2021 |
| WO 2006083245 | A1 | 10-08-2006 | AT | 407749 T | 15-09-2008 |
| | | | CN | 101115572 A | 30-01-2008 |
| | | | EP | 1846176 A1 | 24-10-2007 |
| | | | ES | 2313298 T3 | 01-03-2009 |
| | | | JP | 4609902 B2 | 12-01-2011 |
| | | | JP | 2008532349 A | 14-08-2008 |
| | | | WO | 2006083245 A1 | 10-08-2006 |
| AU 2020103892 | A4 | 11-02-2021 | AU | 2020103892 A4 | 11-02-2021 |
| | | | CN | 111403593 A | 10-07-2020 |
| US 2021190687 | A1 | 24-06-2021 | CN | 108603837 A | 28-09-2018 |
| | | | EP | 3374757 A1 | 19-09-2018 |
| | | | US | 2021190687 A1 | 24-06-2021 |
| | | | WO | 2017184155 A1 | 26-10-2017 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2021167446 A1